Europäisches Patentamt

European Patent Office

Office européen des brevets

(19)

(11) **EP 0 515 718 B1**

(12) **EUROPÄISCHE PATENTSCHRIFT**

(45) Veröffentlichungstag und Bekanntmachung des Hinweises auf die Patenterteilung:
**15.05.1996 Patentblatt 1996/20**

(51) Int Cl.6: **G01R 33/46**

(21) Anmeldenummer: **91108878.9**

(22) Anmeldetag: **30.05.1991**

(54) **Messung von Kreuzrelaxationsraten zwischen ausgesuchten Kernpaaren**

Measurement of cross relaxation rates between selected nucleus pairs

Mesure de taux de relaxation croisée entre des paires de noyaux sélectionnés

(84) Benannte Vertragsstaaten:
**CH DE FR GB LI**

(43) Veröffentlichungstag der Anmeldung:
**02.12.1992 Patentblatt 1992/49**

(73) Patentinhaber: **SPECTROSPIN AG**
**CH-8117 Fällanden (CH)**

(72) Erfinder:
• **Bodenhausen, Geoffrey**
**CH-1009 Pully (CH)**
• **Burghardt, Irene**
**CH-1020 Renens (CH)**
• **Konrat, Robert**
**CH-1110 Morges (CH)**
• **Vincent, Sebastien**
**CH-1018 Lausanne (CH)**

(74) Vertreter: **KOHLER SCHMID + PARTNER**
**Patentanwälte**
**Ruppmannstrasse 27**
**70565 Stuttgart (DE)**

(56) Entgegenhaltungen:
**US-A- 3 795 856** **US-A- 3 975 675**
**US-A- 4 345 207**

• **CHEMICAL PHYSICS LETTERS Band 165, Nr. 6, 2. Februar 1990, Seiten 469-476; L. EMSLEY et al.: "Gaussian pulse cascades: new analytical functions for rectangular selective inversion and in-phase excitation in NMR**
• **JOURNAL OF MAGNETIC RESONANCE Band 82, 1989, Seiten 211-221, Duluth, US; L. EMSLEY et al.: "Self-Refocusing Effect of 270 Gaussian Pulses. Applications to Selective Two-Dimensional Exchange Spectroscopy"**
• **JOURNAL OF MAGNETIC RESONANCE Band 89, Nr. 3, 1. Oktober 1990, Seiten 620-626, Duluth, US; S.M. HOLLET et al.: "Rotational-Echo Triple-Resonance NMR"**

## Beschreibung

Die Erfindung betrifft ein Verfahren zur Messung von Kreuzrelaxationsraten im Laborsystem in der hochauflösenden Kernspinresonanzspektroskopie, bei dem eine vorzugsweise in einer Flüssigkeit gelöste Probensubstanz mit Kernen A und X, die unterschiedliche chemische Verschiebungen $\Omega_A$ und $\Omega_X$ aufweisen, in einem homogenen statischen Magnetfeld $B_0$ in Richtung einer z-Achse, welches einer Ausrichtung der longitudinalen Komponenten $I_z^A$, $I_z^X$ der Magnetisierungsvektoren $\vec{I}^A$, $\vec{I}^X$ der Kerne A, X bewirkt, während eines Zeitintervalls $\tau_m$ mit einem HF-Feld bestrahlt und anschließend die longitudinale Magnetisierung durch eine geeignete HF-Impulssequenz in eine transversale Magnetisierung übergeführt wird, welche ein HF-Signal erzeugt, das mit einem Detektor aufgenommen wird.

Ein solches Verfahren ist aus dem Lehrbuch von D. Neuhaus und M.P. Williamson, The Nuclear Overhauser Effect in Structural and Conformational Analysis, Verlag Chemie, 1989 bekannt.

Seit Solomons bekanntem Werk war es klar, daß die Messung von Kreuzrelaxationsraten eine einzigartige Möglichkeit zur Bestimmung von internuklearen Abständen in Lösungen bieten kann. Die Kreuzrelaxation, die auch als Overhauser Effect bekannt ist, führt zu einem partiellen Austausch von longitudinalen Magnetisierungskomponenten $I_z^A$ und $I_z^X$. Die Rate dieses Prozesses ist im Prinzip proportional zur umgekehrten 6. Potenz des Kernabstandes $r_{AX}$. Ein Problem bei den Kreuzrelaxationsphänomenen ist jedoch, daß sie leicht durch die Anwesenheit weiterer Spins gestört werden. Wenn beispielsweise ein dritter Spin M vorhanden ist, so daß $r_{AM}$ und $r_{MX}$ beide kleiner sind als $r_{AX}$, wird die Konversion von $I_z^A$ in $I_z^X$ über $I_z^M$ viel schneller sein als der direkte Austausch von $I_z^A$ und $I_z^X$, so daß die Messung des Abstandes $r_{AX}$ unverläßlich wird. Lediglich bei isolierten Spinpaaren kann man hoffen, die Abstände mit vernünftiger Genauigkeit zu messen. In größeren Spinsystemen wird oft die Näherung der Anfangsrate herangezogen, um den Gebrauch der zwei-Spin-Näherung zu rechtfertigen. Obwohl diese Näherung für dominante Wechselwirkungen sicherlich akzeptabel ist, kann sie nicht auf schwächere "long range"-Overhauser Effekte angewendet werden, die meist von den stärkeren Wechselwirkungen überschattet werden.

Aufgabe der Erfindung ist es daher, die beschriebenen fundamentalen Schwierigkeiten zu umgehen, und ein Verfahren zur Messung von Kreuzrelaxationsraten vorzustellen, das auch in den Fällen angewendet werden kann, wo der normale Kern-Overhauser Effekt im Laborsystem durch benachbarte Spins gestört ist.

Die Aufgabe wird erfindungsgemäß dadurch gelöst, daß das HF-Feld aus mindestens zwei schwachen, selektiven Teilfeldern zusammengesetzt ist, deren Frequenzen so gewählt sind, daß die Magnetisierungsvektoren $\vec{I}^A$ und $\vec{I}^X$ in eine synchrone Nutationsbewegung versetzt werden, während alle übrigen Kernspins der Probensubstanz im wesentlichen davon unbeeinflußt bleiben.

Die Kerne werden simultan mit den Seitenbändern eines in der Regel amplitudenmodulierten HF-Feldes bestrahlt, so daß ihren Magnetisierungsvektoren synchron eine Nutationsbewegung aufgezwungen wird. Während die Magnetisierungen der zwei ausgesuchten Kerne und X in einem Molekül in diese aufgezwungene Bewegung versetzt werden, kann zwischen den Kernspins eine Kreuzrelaxation stattfinden, die in ihrer Art dem durch die Solomon-Gleichungen beschriebenen Austausch im Laborsystem sehr ähnlich ist. Wenn die Anfangsbedingungen günstig gewählt werden, führt dies zu einfach exponentiellen Zerfällen. Die Kreuzrelaxationsraten können dann aus der Differenz der Zerfallsraten bestimmt werden. Von diesen Kreuzrelaxationsraten können dann internukleare Abstände zwischen den ausgesuchten Kernen abgeleitet werden, und dies sogar in Fällen, wo normale Overhauser-Effekte durch die Anwesenheit von weiteren Spins gestört sind.

Die einfachste Realisierung des erfindungsgemäßen Verfahrens unter Annahme des Fehlens einer schwachen Kopplung $J_{AX}$ zwischen der Spins der Kerne A und X besteht darin, daß die Amplituden und Frequenzen der Teilfelder so gewählt werden, daß sie zusammen ein amplitudenmoduliertes HF-Feld in Richtung einer zur z-Achse orthogonalen y-Achse mit einer Trägerfrequenz $\omega_{rf} = 1/2\,(\Omega_A + \Omega_X)$ und zwei Seitenbandfrequenzen $\omega_{rf} + \omega_a$ und $\omega_{rf} - \omega_a$ ergeben, wobei $\omega_a = 1/2\,(\Omega_A - \Omega_X)$ bedeutet.

Insbesondere kann eine rein sinusoidale Amplitudenmodulation derart gewählt werden, daß die Feldamplitude des zusammengesetzten HF-Feldes der Funktion $2\gamma_1 B_1 \cos \omega_a t$ folgt, wobei $\gamma_1 B_1/2\pi$ die Amplitude der beiden Seitenbänder bedeutet.

In Systemen mit skalaren Kopplungen der Spins der Kerne A und X zu anderen Kernen (z.B. M, K) sollten die Seitenbandamplituden $\gamma_1 B_1/2\pi$ so groß gewählt werden, daß den Spins der Kerne A und X eine Nutationsbewegung derselben Nutationsfrequenz aufgezwungen wird, aber klein genug, um die Spins aller benachbarten andersartigen Kerne nicht zu beeinflussen, insbesondere $10\,\text{Hz} \leq \gamma_1 B_1/2\pi \leq 100\,\text{Hz}$, vorzugsweise $\gamma_1 B_1/2\pi \approx 50\,\text{Hz}$.

Wenn das Zeitintervall $\tau_m$ als ganzzahliges Vielfaches der Dauer eines Modulationszyklus $2\pi/\gamma_1 B_1$ gewählt wird, befindet sich die Magnetisierung der Kerne A und X am Ende der Bestrahlung mit dem zusammengesetzten HF-Feld wieder vollständig in z-Richtung.

Bei einer weiteren Ausführungsform des erfindungsgemäßen Verfahrens wird ein sowohl amplituden- als auch phasenmoduliertes zusammengesetztes HF-Feld eingestrahlt. Dabei sind die Phasen der Teilfelder um 90° gegeneinander verschoben und ihre Amplituden und Frequenzen werden so gewählt, daß sie zusammen ein phasenmoduliertes HF-Feld orthogonal zur z-Achse mit einer Trägerfrequenz $\omega_{rf} = 1/2\,(\Omega_A + \Omega_X)$ und zwei Seitenbandfrequenzen $\omega_{rf} + \omega_a$ und $\omega_{rf} - \omega_a$ ergeben.

Bei einer bevorzugten Ausführungsform folgt die Feldamplitude eines Teilfeldes der Funktion $\gamma_1 B_1 \cdot \cos\omega_a t$ und die Feldamplitude eines weiteren Teilfeldes der Funktion $\gamma_2 B_2 \cdot \cos\omega_a t \cdot \cos\gamma_1 B_1 t$. Dadurch wird eine Art Spin-Lock der Magnetisierungsvektoren $\vec{I}^A$ und $\vec{I}^X$ bewirkt.

Um ein optimales beobachtbares Signal zu erhalten, muß der Spin-Lock-Impuls nach einer ganzzahligen Anzahl von Spinumlaufzyklen der Dauer $2\,\pi/\gamma_2 B_2$ unterbrochen werden, was dadurch erreicht werden kann, daß das Zeitintervall $\tau_m$ als ganzzahliges Vielfaches einer Zyklusdauer $2\pi/\gamma_2 B_2$ gewählt wird.

Ebenso wie bei der obengenannten Ausführungsform eines rein amplitudenmodulierten HF-Feldes sollten im Falle skalarer Kopplungen zu Spins benachbarter anderartiger Kerne auch bei dem amplituden- und phasenmodulierten HF-Feld die Feldamplitude der Teilfelder klein genug sein, um die Spins der benachbarten andersartigen Kerne nicht zu beeinflussen. Andererseits sollte die HF-Amplitude groß genug sein, um die Resonanzen der Spins der Kerne A und X zu "locken". Daher werden bei einer bevorzugten Ausführungsform die Extremamplituden $\gamma_1 B_1/2\pi$ und $\gamma_2 B_2/2\pi$ so gewählt, daß $10\,Hz \leq \gamma_1 B_1/2\,\pi \leq 100\,Hz$, vorzugsweise $\gamma_1 B_1/2\pi \approx 50\,Hz$, und $\gamma_1 B_1/\gamma_2 B_2 \geq 1$, insbesondere $\gamma_1 B_1/\gamma_2 B_2 \approx 10$.

Bei einer besonders bevorzugten Ausführungsform werden die Phasen aller Teilfelder während des Zeitintervalls $\tau_m$ mindestens einmal um 180° geklappt. Damit kann der negative Effekt der inhomogenen Verbreiterung der induzierten Nutationsfrequenzen aufgrund nicht-ideal homogener HF-Felder minimiert werden, was auf eine Refolussierung der inhomogenen Dephasierung hinausläuft.

Aus Symmetriegründen empfielt es sich, die Anzahl der Phasenumklappungen während eines Zeitintervalls $\tau_m$ ungeradzahlig und die zeitliche Dauer $\tau_{180}$ der Einstrahlung des HF-Feldes mit um 180° geklappter Phase gleich der zeitlichen Dauer $\tau_0$ der Einstrahlung des HF-Feldes mit um 0° geklappter Phase zu wählen.

Um destruktive Interferenzen zu vermeiden, werden vorzugsweise die Zeitdauern der einzelnen Intervalle mit umgeklappter Phase jeweils gleich und als ungeradzahliges Vielfaches von $\pi/\omega_a$ gewählt.

Um eine die definierte Anfangsbedingung eines antisymmetrischen Zustandes $\Delta = I_z^A - I_z^X$ mit antiparallelen Spins der Kerne A und X zu erzeugen, kann bei Ausführungsformen der Erfindung die Probensubstanz vor Einstrahlung des zusammengesetzten HF-Feldes mit einer geeignet geformten selektiven HF-Impulssequenz bestrahlt werden, welche die Invertierung der Spinpolarisation der Kerne X gegenüber den Kernen A bewirkt.

Eine solche selektive HF-Impulssequenz kann aus einer $G^3$-Gauß Kaskade bestehen, wie sie in einem Artikel von L. Emsley und G. Bodenhausen in Chem. Phys. Lett. 165, 469 (1990) beschrieben wird.

Eine verbesserte Charakteristik kann mit bandselektiven "Uniform response pure phase"-Impulsen erhalten werden, die von H. Geen, S. Wimperis und R. Freemann in J. Magn. Reson. 85, 620 (1989) vorgeschlagen werden.

Dennoch kann die selektive Invertierung der Spinpolarisation in der Praxis nie perfekt vollzogen werden. Der real erreichbare antisymmetrische Anfangszustand mit antiparallelen Spins wird daher immer vom idealen Eigenzustand des Systems abweichen, was zu einem mehr oder minder bi-exponentiellen Zerfall der Spins führt. Im Gegensatz dazu zeigt der symmetrische Eigenzustand $\Sigma = I_z^A + I_z^X$ mit parallelen Spins der Kerne A und X grundsätzlich immer einen mono-exponentiellen Zerfall.

Bei anderen Ausführungsformen der Erfindung wird die Symmetrie dadurch hergestellt, daß die Probensubstanz vor Einstrahlung des zusammengesetzten HF-Feldes mit einer HF-Impulssequenz bestrahlt wird, welche eine transversale Magnetisierung der Kerne A und X anregt.

Vorzugsweise wird die HF-Impulssequenz mit $\sin\omega_a t$ oder $\cos\omega_a t$ amplitudenmoduliert. Damit wird eine phasenrichtige transversale Magnetisierung über wohl definierte schmale Bandbreiten angeregt.

Dabei können als HF-Impulssequenz die in einem Artikel von L. Emsley und G. Bodenhausen in J. Magn. Reson. 82, 211 (1989) beschriebenen 270°-Gauß-Impulse Anwendung finden.

Für den Fall, daß die experimentellen Bedingungen nicht ganz ideal sind, können die definierten Anfangsbedingungen mit transversaler Magnetisierung auch dadurch erreicht werden, daß als selektive HF-Impulssequenzen $G^4$-Gauß-Impulskaskaden gewählt werden, die ebenfalls in dem oben zitierten Artikel von L. Emsley und G. Bodenhausen in Chem. Phys. Lett. 165, 469 (1990) beschrieben sind.

Falls eine skalare Kopplung zwischen den Spins der Kerne A und X auftritt, d.h., wenn die skalare Kopplungskonstante $J_{AX} \neq 0$, tritt ein kohärenter Austausch der Magnetisierung zwischen den Kernen A und X auf. Dieser beeinflußt das Meßergebnis dann nicht, wenn sich das System zu Beginn des Zeitintervalls $\tau_m$ in einem symmetrischen, phasengleichen Magnetisierungszustand $\Sigma = I_z^A + I_z^X$, $\Sigma' = I_x^A + I_x^X$ oder $\Sigma'' = I_y^A + I_y^X$ befindet.

Im Falle eines Anfangszustandes mit entgegengesetzten Phasen hingegen werden die Observablen durch die skalare Kopplung moduliert. Am einfachsten kann diese Modulation vom langsamen inkohärenten Spinaustausch durch eine Fourier-Transformation bezüglich $\tau_m$ abgespalten werden.

Als einfacher kann es sich in der Praxis erweisen, bei aufeinanderfolgenden Messungen das jeweilige Zeitintervall $\tau_m$ um ganzzahlige Vielfache der Schwingungsperiode die von einer skalaren Kopplung zwischen den Spins der Kerne A und X verursacht wird, zu inkrementieren.

Um die longitudinale Magnetisierung der Kerne A und X am Ende der Bestrahlung mit dem zusammengesetzten HF-Feld in eine beobachtbare transversale Magnetisierung überzuführen, bieten sich mehrere Möglichkeiten an:

Bei einer Ausführungsform wird als Leseimpuls unmittelbar nach Abschluß der Bestrahlung mit dem zusammengesetzten HF-Feld ein 270°-Gauß-Impuls mit der Frequenz einer der beiden chemischen Verschiebungen $\Omega_A$ oder $\Omega_X$ eingestrahlt.

Bei einer weiteren Ausführungsform wird als Leseimpuls unmittelbar nach Abschluß der Bestrahlung mit dem zusammengesetzten HF-Feld ein 270°-Gauß-Impuls eingestrahlt, der mit der Funktion $\cos\omega_a t$ amplitudenmoduliert ist. Dadurch werden beide Kernresonanzfrequenzen simultan "getroffen".

Schließlich kann bei einer weiteren Ausführungsform auch ein nicht-selektiver $\pi/2$-Impuls eingestrahlt werden.

Um sicherzustellen, daß wirklich nur die übrig bleibende z-Magnetisierung und nicht andere transversale Komponenten gemessen werden, wird bei einer bevorzugten Ausführungsform die Phase der Leseimpulse alterniert und damit gekoppelt das Meßsignal im Detektor alternierend addiert bzw. subtrahiert.

Die Erfindung wird im Folgenden anhand der in der Zeichnung dargestellten Ausführungsbeispiele näher beschrieben und erläutert. Es zeigen:

Fig. 1a    Simulationen des oszillierenden Zerfalls von $I_z^A$ in einem 2-Spin-System AX mit $J_{AX} = 0$, wenn beiden Magnetisierungsvektoren durch die beiden Seitenbänder eines amplitudenmodulierten HF-Feldes eine Nutationsbewegung aufgezwungen wird, wobei das System mit der Anfangsbedingung $\sigma(0) = I_z^A$ startet und die Oszillationsfrequenz zur Amplitude $\gamma_1 B_1$ des HF-Feldes korrespondiert, welches als perfekt homogen angenommen wird, und zwar im Grenzfall langsamer Bewegung (1) und im Grenzfall schneller Bewegung (2);

Fig. 1b    Simulationen für den Aufbau von $I_z^X$ unter den gleichen Bedingungen wie Fig. 1a und zwar für den Grenzfall langsamer Bewegung (3) und den Grenzfall schneller Bewegung (4);

Fig. 2    Simulationen der oszillierenden exponentiellen Zerfälle der normalen Moden in einem 2-Spin-System AX mit $J_{AX} = 0$ für $\Sigma = I_z^A + I_z^X$     (5) und $\Delta = I_z^A - I_z^X$     (6) , wobei die Magnetisierungsvektoren durch die beiden Seitenbänder eines amplitudenmodulierten HF-Feldes wie in Fig. 1 zu einer Nutationsbewegung gezwungen werden;

Fig. 3a    die Molekülformel mit Identifizierung der gemessenen Protonen;

Fig. 3b und c experimentelle oszillierende Zerfälle der normalen Moden in dem AK Spin-Subsystem des untersuchten Moleküls Exifone, wobei $J_{AK} = 0$ und

b) $\Sigma = I_z^X + I_z^K$ und
c) $\Delta = I_z^X - I_z^K$ ;

Fig. 4a bis 4c schematisierte HF-Impulssequenzen mit zugehörigem Phasenumklappschema, wobei

a) der Bestrahlung mit einem amplitudenmodulierten HF-Feld mit den Seitenbandfrequenzen $\Omega_A$ und $\Omega_X$ ein selektiver 270°-Gauß-Impuls bei $\Omega_A$ oder $\Omega_X$ folgt, um die transversale Magnetisierung der Spins A oder X anzuregen;
b) dem Zeitintervall $\tau_m$ eine selektive $G^3$-Gauß-Impulskaskade bei $\Omega_A$ oder $\Omega_X$ vorangeht, um die Magnetisierung der Spins A oder X zu invertieren, und dem Zeitintervall $\tau_m$ ein selektiver 270°-Gauß-Impuls bei $\Omega_A$ oder $\Omega_X$ folgt, um die transversale Magnetisierung der Spins A oder X anzuregen;
c) im Zeitintervall $\tau_m$ ein amplitudenmodulierter, selektiver 270°-Gauß-Impuls bei $\Omega_A$ und $\Omega_X$ vorangeht, um die transversale Magnetisierung der Spins A und X anzuregen, und dem Zeitintervall $\tau_m$ ein selektiver 270°-Gauß-Impuls bei $\Omega_A$ oder $\Omega_X$ folgt, um die transversale Magnetisierung der Spins A oder X anzuregen;

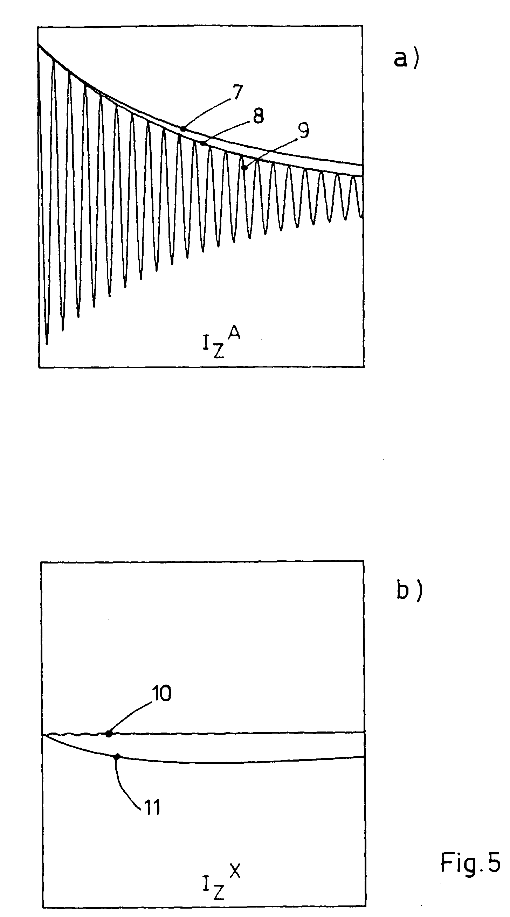

Fig. 5a    Simulationen des Zerfalls von $I_z^A$ und des Aufbaus von $I_z^X$ in einem 2-Spin-System AX mit $J_{AX} = 0$ im Grenzfall schneller Bewegung, wobei das System mit der Anfangsbedingung $\sigma(0) = I_z^A$ startet und die Oszillationsfrequenz einer Amplitude $\gamma_1 B_1$ des HF-Feldes, das längs der y-Achse angelegt wird und als perfekt homogen angenommen ist, entspricht, und zwar für

a) normalen Zerfall von $I_z^A$ im Laborsystem (7), Zerfall von $I_z^A$, wenn nur X bestrahlt wird (8), Zerfall von $I_z^A$, wenn nur A bestrahlt wird (9);

b) Fehlen eines Aufbaus von $I_z^X$, wenn nur A oder nur X bestrahlt wird (10), und normalen Aufbau von $I_z^X$ im Laborsystem (11).

Bei dem im Folgenden beschriebenen Verfahren wird von einem amplitudenmodulierten HF-Feld mit einer Trägerfrequenz $\omega_{rf} = 1/2 (\Omega_A + \Omega_X)$ Gebrauch gemacht, die symmetrisch zwischen den chemischen Verschiebungen $\Omega_A$ und $\Omega_X$ der interessierenden Kerne A und X liegt. Die Amplitude wird mit der Frequenz $\omega_a = 1/2 (\Omega_A - \Omega_X)$ moduliert, so daß die Seitenbänder bei $\omega_{rf} \pm \omega_a$ mit den beiden chemischen Verschiebungen $\Omega_A$ und $\Omega_X$ zusammenfallen. Das einfachste Experiment dieser Art benötigt lediglich ein zusammengesetztes oszillierendes HF-Feld. Wenn die Spins der Kerne A und X keine skalare Kopplung $J_{AX}$ besitzen und man das Experiment in einem mit der Trägerfrequenz $\omega_{rf}$ rotierenden Koordinatensystem beschreibt, so hat der Hamilton-Operator die folgende Form:

$$H = 2\gamma_1 B_1 \cos\omega_a t(I_y^A + I_y^X) + \omega_a(I_z^A - I_z^X) \qquad (1)$$

Der Term $2\gamma_1 B_1$ korrespondiert zu einem schwachen HF-Feld längs der y-Achse im rotierenden Koordinatensystem und wird mit $\cos\omega_a t$ moduliert, so daß jeder der beiden Seitenbänder eine Amplitude $\gamma_1 B_1$ aufweist. Der zweite Term beschreibt die beiden chemischen Verschiebungen, die bezüglich der Trägerfrequenz $\omega_{rf}$ bei $\pm \omega_a$ erscheinen. Die modulierte HF-Bestrahlung muß an das Spinsystem während eines Zeitintervalls $\tau_m$ angelegt werden, das typischerweise lang genug ist, daß sich die Kreuzrelaxationseffekte manifestieren können. Typisch kann das Zeitintervall $\tau_m$ zwischen 10 ms und 10s liegen.

Eine ähnliche HF-Modulation kann bei skalar-gekoppelten Spinsystemen AX angewendet werden, um einen Kohärenztransfer zu bewirken. In Systemen mit einer schwachen skalaren Kopplung muß zum Hamilton-Operator der Gl. (1) ein weiterer Term $2\pi J_{AX} I_z^A I_z^X$ addiert werden. Bei den sogenannten doppelt-selektiven homonuklearen Hartmann-Hahn-Experimenten muß die Magnetisierung eines ausgewählten Ortes im Molekül, beispielsweise Spin A, durch einen selektiven HF-Impuls vor dem Anlegen der amplitudenmodulierten Bestrahlung in Richtung der y-Achse ausgerichtet werden. Diese Komponente wird dann "Spin-gelockt", und, vorausgesetzt es gibt eine skalare Kopplung $J_{AX}$, wird ein kohärenter Transfer von transversaler Magnetisierung zwischen A und X auftreten, der mit einer Periode von $2/J_{AX}$ oszilliert. Dieser Prozeß kann als Test für die Existenz einer skalaren Kopplung zwischen zwei willkürlich ausgewählten Spins benutzt werden.

Im folgenden werden wir jedoch unsere Aufmerksamkeit auf Kreuzrelaxationen richten, wobei wir zunächst annehmen, daß $J_{AX} = 0$. Der Effekt des Hamilton-Operators von Gl.(1) auf das Spinsystem hängt von den Anfangsbedingungen ab. Falls die Magnetisierung parallel zum HF-Feld ist, (wie bei dem homonuklearen Hartmann-Hahn-Experiment), kann Kreuzrelaxation nicht auftreten. Wenn nämlich die beiden Magnetisierungsvektoren durch unterschiedliche HF-Felder gelockt werden, die mit $\omega_{rf} \pm \omega_a$ präzessieren, dann mittelt sich die Kreuzrelaxation zu Null weg. Dieses Versagen überrascht nicht, wenn man bedenkt, daß in der Redfield-Theorie die nicht-säkularen Terme vernachlässigt werden können, und er ist konsistent mit den von Griesinger et al. eingeführten "Invarianten Trajektorien".

Falls die Anfangsbedingung vor Anlegen des amplitudenmodullierten HF-Feldes längs der y-Achse geeignete Spinkomponenten $I_z^A$ oder $I_X^A$ enthält, die orthogonal zum HF-Feld sind, werden die Magnetisierungsvektoren gezwungen, in der xz-Ebene zu nutieren, d.h. in einer Ebene orthogonal zum HF-Feld. In diesem Fall kann in der Tat Kreuzrelaxation auftreten, vorausgesetzt, die Nutationsfrequenz $\gamma_1 B_1$ ist die gleiche für beide Spins A und X.

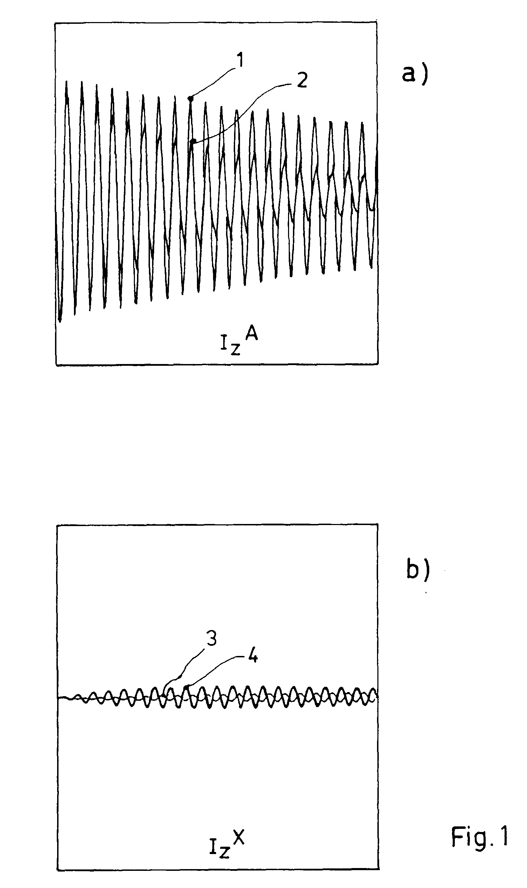

Um diesen Mechanismus zu erläutern, nehmen wir zunächst an, daß wir den Gleichgewichtsdichteoperator $\sigma^{eq} = I_z^A + I_z^X$ beispielsweise durch Sättigung der X-Spinübergänge so modifizieren können, daß wir $\sigma(0) = I_z^A$ erhalten. Fig. 1 zeigt, wie während der Bestrahlung im Zeitintervall $\tau_m$ die Spinkomponente $I_z^A$ mit einer Frequenz $\gamma_1 B_1$ oszilliert, weil die Magnetisierung zur Nutation in der xz-Ebene gezwungen wird. Die Spinkomponente $I_z^A$ zerfällt auch aufgrund der Relaxation. In den Simulationen von Fig. 1 wird das HF-Feld als perfekt homogen angenommen. Gleichzeitig beobachtet man einen langsamen Aufbau der Spinkomponente $I_z^X$, der einer schnellen Oszillation mit der Frequenz $\gamma_1 B_1$ überlagert ist. Bedenkt man, daß die zwei Magnetisierungsvektoren synchron zu Nutationsbewegungen gezwungen werden, oszillieren ihre z-Komponenten mit der gleichen Phase und ihr Austausch kann durch Gleichungen des Solomon-Typs beschrieben werden:

$$\frac{d}{dt} \begin{pmatrix} <I_z^A> \\ <I_z^X> \end{pmatrix} = - \begin{pmatrix} \rho'_A & \sigma'_{AX} \\ \sigma'_{AX} & \rho'_X \end{pmatrix} \begin{pmatrix} <\Delta I_z^A> \\ <\Delta I_z^X> \end{pmatrix} \qquad (2)$$

wobei $\Delta$ eine Abweichung vom Gleichgewicht repräsentiert und die Raten $\rho'_A$, $\rho'_X$ und $\sigma_{AX}$ sich von ihren Gegenstücken im Laborsystem dadurch unterscheiden, daß sie als Mittelwerte über den Nutationszyklus berechnet werden. Wenn beide Magnetisierungskomponenten längs der z-Achse ausgerichtet sind, kann der Austausch von Magnetisierung stattfinden. Wenn die Komponenten transversal sind, präzessieren sie mit unterschiedlichen Frequenzen $+\omega_A$ und $-\omega_A$, so daß, im Gegensatz zu der auf die ROESY-Experimente zutreffenden Situation, die transversale Kreuzrelaxation weggemittelt wird. Die Kreuzrelaxationsrate wird einfach geschwächt, d.h. $\sigma'_{Ax} = \lambda \, \sigma_{AZ}$, wobei gezeigt werden kann, daß der Faktor $\lambda = 2/\pi = 0{,}637$ ist.

Die Zerfalls- und Aufbau-Kurven von Fig. 1 sind bi-exponentiell und schwierig zu messen. Es stellt sich heraus, daß es ziemlich einfach ist, Anfangsbedingungen in einer solchen Weise aufzustellen, daß man einfach-exponentielle Zerfälle erhält, vorausgesetzt $\rho'_A = \rho'_X = \rho'$ (was für reine dipolare Relaxation gilt, oder wenn äußere Felder und die Anisotropie der chemischen Verschiebungen den gleichen Effekt auf beide Orte im Molekül haben). Die beiden Zustände

$$\Sigma = I_z^A + I_z^X \qquad (3)$$

$$\Delta = I_z^A - I_z^X \qquad (4)$$

korrespondieren zu Eigenvektoren (manchmal auch "normale Moden" genannt) der gekoppelten Differentialgleichungen (2),

$$\Sigma(\tau_m) = \Sigma(0)\exp\{-R_1 \tau_m\}\cos(\gamma B_1 \tau_m)$$

$$R_1 = 2\rho' + 2\sigma'_{AX} \qquad (5)$$

$$\Delta(\tau_m) = \Delta(0)\exp\{-R_2 \tau_m\}\cos(\gamma B_1 \tau_m)$$

$$R_2 = 2\rho' - 2\sigma'_{AX} \qquad (6)$$

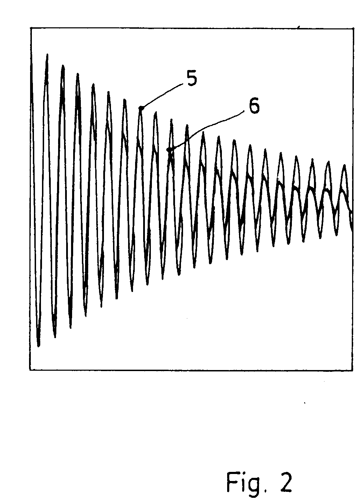

wobei die consinusoidale Modulation von der kohärenten Nutation um die HF-Felder stammt. Diese Ausdrücke gelten nur für $\gamma B_1 \gg R_1, R_2$. Eine realistische, numerische Simulation der Zeitabhängigkeit der Summen- und Differenz-Moden ist in Fig. 2 gezeigt. Beide Moden zeigen einen einfach-exponentiellen Zerfall.

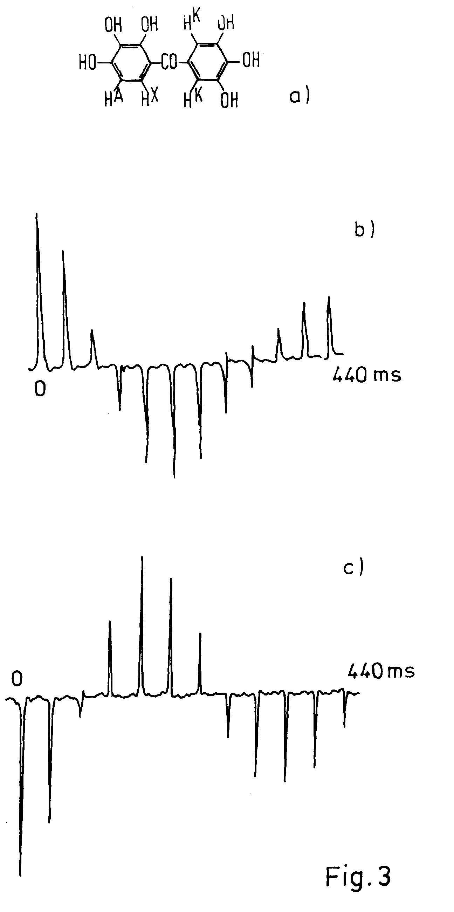

Fig. 3 zeigt experimentelle Ergebnisse, die die Gültigkeit der rechnerischen Simulationen bestätigen.

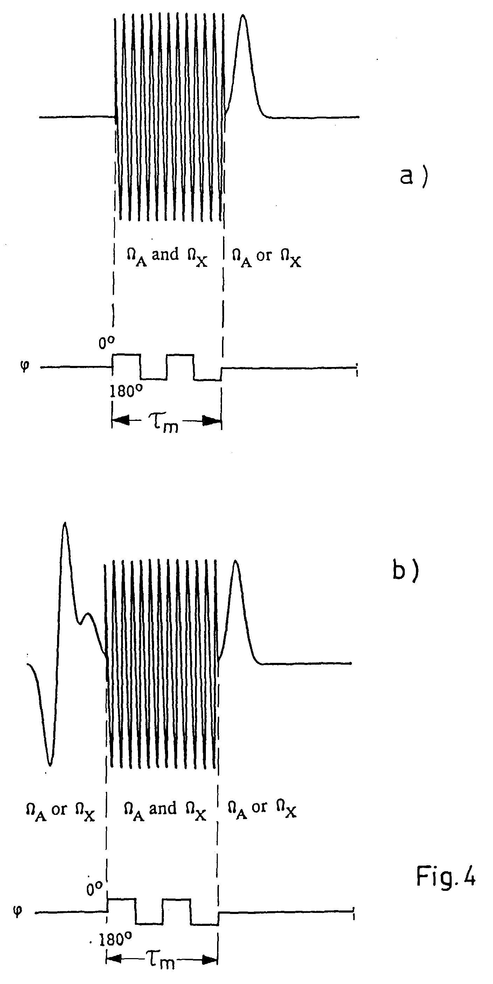

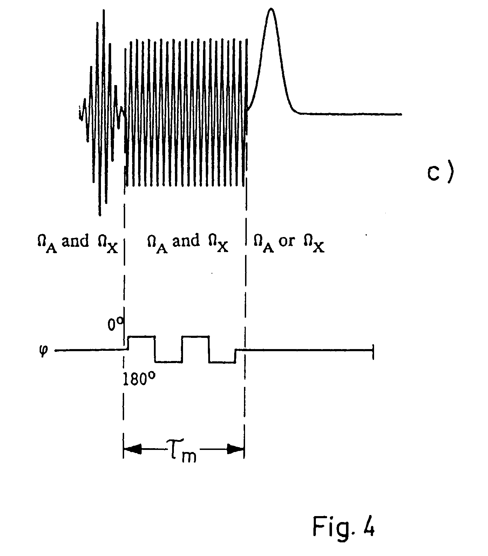

Die Anfangsbedingung von Gl. (4) kann durch Invertierung der Polarisation des Spins X mit einem geeignet geformten selektiven Impuls realisiert werden. Zu diesem Zweck können beispielsweise $G^3$-Gauß-Impulskaskaden verwendet werden, wie in Fig. 4b gezeigt.

Verbesserte Charakteristiken können auch mit bandselektiven (Uniform response pure phase-Impulsen) erzielt werden. Eine selektive Inversion ist jedoch nie perfekt, so daß man mit einer Anfangsbedingung $\sigma(0) = I_z^A - K \, I_z^X$ leben muß, wobei typischerweise gilt $0{,}8 \le k \le 1$. Das bedeutet natürlich auch, daß der Anfangszustand kein idealer Eigenvektor ist, und daß folglich der Zerfall (zumindest leicht) bi-exponentiell sein wird. Andererseits zeigt die Summenmode $\Sigma = I_z^A + I_z^X$ jederzeit einen idealen mono-exponentiellen Zerfall.

Die Symmetrie kann dadurch hergestellt werden, daß vor der Bestrahlung mit dem amplitudenmodulierten HF-Feld die transversale Magnetisierung angeregt wird, um folgende unterschiedliche Anfangsbedingungen zu etablieren:

$$\Sigma' = I_x^A + I_x^X \qquad (7)$$

$$\Delta' = I_x^A - I_x^X \qquad (8)$$

In beiden Fällen sind die Magnetisierungskomponenten orthogonal zu dem HF-Feld, welches längs der y-Achse wie in Gl. (1) beschrieben angelegt wird, so daß die Magnetisierungsvektoren wiederum zur Nutation in der xz-Ebene gezwungen werden. Transversale Magnetisierung kann durch Anlegen eines 270°-Gauß-Impulses vor dem Zeitintervall $\tau_m$ der Bestrahlung mit dem HF-Feld angeregt werden (siehe Fig. 4). Die Anfangsbedingungen von Gln (7) und (8) können leicht erhalten werden, wenn die Amplitude dieses Gauß-Impulses ähnlich moduliert wird, wie das nachfolgende HF-Feld. Dies ist schematisch in Fig. 4c gezeigt. Dadurch wird es ermöglicht, eine transversale Magnetisierung in Phase über recht gut definierte enge Bandbreiten anzuregen. Kompliziertere Impulsformen wie beispielsweise $G^4$-Impulskaskaden können im Zusammenhang mit der Amplitudenmodulation ebenfalls verwendet werden. Wenn der Anregungsimpuls mit $\cos \omega_a t$ moduliert wird, werden die beiden Magnetisierungskomponenten längs der +x-Achse ausgerichtet, während ein mit $\sin \omega_a t$ modulierter Impuls die beiden Vektoren längs der + x bzw. - x-Achse ausrichten wird.

Diese Schemata haben den Vorteil, daß man Anfangsbedingungen erhalten kann, die zu den normalen Moden von Gln (7) und (8) auch dann korrespondieren, wenn die experimentellen Bedingungen nicht ganz ideal sind.

Die Zerfallsraten der normalen Moden können leicht durch Aufnahme von Spektren für unterschiedliche Zeitintervalle $\tau_m$ der modulierten HF-Bestrahlung gemessen werden. Die Differenz dieser Raten beinhaltet unmittelbar die Kreuzrelaxationsrate:

$$(1/4)(R_1 - R_2) = \sigma'_{AX} = \lambda \sigma_{AX} \qquad (9)$$

$$\lambda = 2/\pi$$

$$\sigma_{AX} = -(1/3) J_{AXAX}(0) + 2 J_{AXAX}(2\omega_A).$$

mit der spektralen Leistungsdichte der Autokorrelation

$$J_{AXAX}(\omega_A) = (3/10)(\mu_0/4\pi)^2 \gamma_A^2 \gamma_X^2 \hbar^2 <r_{AX}^{-3}>^2 [\tau_c/(1+\omega_A^2 \tau_c^2)] \qquad (10)$$

Dabei bedeuten $J_{AXAX}(\omega_A)$ die spektrale Leistungsdichte der Autokorrelation in einem 2-Spinsystem AX in Abhängigkeit von der Larmorfrequenz $\omega_A$ des Kernes A, $\mu_0$ die Permeabilität des Vakuums, $\gamma_{A,X}$ die gyromagnetischen Verhältnisse der Kerne A, X, $\hbar = h/2\pi$ die modifizierte Planck'sche Wirkungskonstante, $r_{AX}$ den Abstand der Kerne A und X und $\tau_c$ die Korrelationszeit der molekularen rotationellen Diffusion. Man beachte, daß im Grenzfall langsamer Bewegung $J_{AXAX}(0) \gg J_{AXAX}(2\omega_A)$, folglich $\sigma_{AX} < 0$, so daß $R_2 > R_1$ gilt. Mit anderen Worten zerfällt in diesem Fall die Differenzmode $\Delta$ schneller als die Summenmode $\Sigma$. Das Umgekehrte trifft auf den Grenzfall schneller Bewegung zu.

Trotz der Anwesenheit des HF-Feldes sei darauf hingewiesen, daß das erfindungsgemäße Verfahren die Kreuzrelaxationsrate im Laborsystem ergibt, d.h. die gleiche Rate, die man normalerweise in Abwesenheit von HF-Bestrahlung mißt, wie in den sogenannten "NOESY"-Experimenten und nicht die Rate, die für das rotierende Koordinatensystem wie bei "ROESY"-Experimenten anwendbar ist. Man beachte in Fig. 1, dem Grenzfall schneller Bewegung, daß die Amplituden von $I_z^A$ und $I_z^X$ jeweils immer entgegengesetzte Vorzeichen haben, während im Grenzfall langsamer Bewegung diese Amplituden zu jeder Zeit im Modulationszyklus das gleiche Vorzeichen besitzen. Dies ist ebenfalls analog zu dem transienten Overhauser-Effekt im Laborsystem.

Wie bei konventionellen Overhauser-Studien erlaubt eine Kalibration mit Hilfe von Experimenten, bei denen Kernpaare mit bekannten Kernabständen und ähnlichen Korreationszeiten involviert sind, aus der Messung der Kreuzrelaxationsrate einen unbekannten internuklearen Abstand $r_{AX}$ zu bestimmen. Im Gegensatz zu den konventionellen Experimenten können allerdings bei Anwendung des erfindungsgemäßen Verfahrens Störungen aufgrund von anderen Spins, zumindest, wenn deren chemische Verschiebungen genügend weit von den beiden Seitenbändern der modulierten HF-Einstrahlung entfernt sind, ignoriert werden.

In der bisherigen Diskussion haben wir angenommen, daß $J_{AX} = 0$ gilt, was in der Tat oft zutrifft, wenn man Overhauser-Effekte zwischen Spins studiert, die beispielsweise auf unterschiedlichen Aminosäuren eines Peptids oder eines Proteins lokalisiert sind. Falls jedoch die skalare Kopplungskonstante $J_{AX}$ (nicht zu verwechseln, mit der spektralen Leistungsdichte der Autokorrelation $J_{AXAX}$) nicht verschwindet, wird ein kohärenter Austausch von Magnetisierung stattfinden. Dies wird das Experiment dann nicht beeinträchtigen, wenn mit einer In-Phasen-Magnetisierung gestartet wird, es wird jedoch zu einer Modulation der Beobachtungsgrößen führen, wenn man mit entgegengerichteten Phasen beginnt. Diese Modulation kann im Prinzip vom langsamen inkohärenten Austausch durch Fourier-Transformation bezüglich $\tau_m$ abgespalten werden. Wenn jedoch $J_{AX}$ bekannt ist, kann es in der Praxis einfacher sein, $\tau_m$ in Vielfachen der Schwingungsperiode, die durch die skalare Kopplung hervorgerufen wird, zu inkrementieren.

In Systemen mit verschwindenden skalaren Kopplungen $J_{AM}$, $J_{KX}$ zu "passiven" Spins M und K sollte die HF-Amplitude $\gamma_1 B_1$ genügend groß gewählt werden, um alle Resonanzen der Spins A und X zu einer Nutationsbewegung mit der gleichen Nutationsfrequenz zu zwingen. Falls diese Bedingung erfüllt ist, werden die skalaren Kopplungen $J_{AM}$ und $J_{KX}$ während des Zeitintervalls $\tau_m$ effektiv entkoppelt. Auf der anderen Seite sollte aber $\gamma_1 B_1$ schwach genug sein, so daß benachbarte "passive" Spins nicht berührt werden. Typischerweise erscheint eine Amplitude von $\gamma_1 B_1/2\pi \approx 50$ Hz als vernünftiger Kompromiß.

Diese etwas widersprüchlichen Erfordernisse können einfacher zu erfüllen sein, wenn die Magnetisierung nach Art von Spin-Locking-Experimenten längs des effektiven Feldes ausgerichtet wird. Diese Beobachtung führt zu einem alternativen Ansatz, bei dem eine Bestrahlung mit einem HF-Feld vorgesehen ist, das sowohl amplituden- als auch phasenmoduliert ist. In einem mit $\omega_{rf}$ rotierenden Koordinatensystem hat der Hamilton-Operator während des Zeitintervalls $\tau_m$ der Bestrahlung mit dem HF-Feld folgende Form:

$$H = [2\gamma_1 B_1(I_y^A + I_y^X) + 4\gamma_2 B_2 \cos\gamma_1 B_1 t(I_x^A + I_x^X)]\cos\omega_a t$$

$$+ \omega_a(I_z^A - I_z^X) \qquad (11)$$

Dieser Hamilton-Operator kann mit folgenden Anfangsbedingungen benutzt werden:

$$\Sigma'' = I_y^A + I_y^X \qquad (12)$$

$$\Delta''=I_y^A-I_y^X \tag{13}$$

Der $2\gamma_1B_1$-Term im Hamilton-Operator, der wiederum mit $\cos\omega_a t$ so moduliert wird, daß das HF-Spektrum in zwei Seitenbänder aufspaltet, von denen jedes die Amplitude $\gamma_1B_1$ aufweist, erlaubt einen Spin-Lock der beiden Magnetisierungsvektoren. Die HF-Amplitude sollte groß genug gewählt werden, um die Spinresonanzen der Kerne A und X effektiv zu "locken", auch wenn sie in Multipletts aufgrund von skalaren Kopplungen mit den umgebenden Spins aufspalten. Andererseits sollte $\gamma_1B_1$ schwach genug sein, so daß benachbarte "passive" Spins nicht berührt werden. Typischerweise erscheint auch in diesem Fall die Wahl einer Amplitude $\gamma_1B_1/2\pi \approx 50$ Hz als vernünftiger Kompromiss.

Der zweite Term in Gl (11) korrespondiert zu einem Feld $4\gamma_2B_2$, das längs der x-Achse des rotierenden Koordinatensystems angelegt wird und orthogonal zum ersten $B_1$-Feld ist. Um den Zweck dieses zweiten Feldes zu verstehen, sei in Erinnerung gerufen, daß in dem Fall, wenn die Magnetisierung mit dem spin-lockenden Hauptfeld $B_1$ längs der y-Achse ausgerichtet ist, die Magnetisierung um $B_1$ mit einer Frequenz $\gamma_1B_1$ präzediert. Nun spaltet die Modulation des zweiten Feldes mit $\cos\omega_\alpha t$ ebenfalls dessen Spektrum in zwei Seitenbänder bei den Frequenzen $\omega_{rf} \pm \omega_a$ auf, wobei beide eine Amplitude von jeweils $2\gamma_2B_2$ aufweisen.

Zusätzlich ist das zweite Feld mit der Frequenz $\gamma_1B_1$ moduliert. Im rotierenden Koordinatensystem, wo die chemischen Verschiebungen $\Omega_1$ oder $\Omega_2$ stationär erscheinen, oszilliert das Feld $2B_2$ längs der $\pm$ x-Achse. Dieses Feld kann in zwei gegenläufig rotierende Teilkomponenten zerlegt werden, von denen jede eine Amplitude $B_2$ aufweist, und die in einer Ebene senkrecht zum Magnetisierungsvektor präzedieren. Da das $B_2$-Feld mit der Frequenz $\gamma_1B_1$ oszilliert, wird zu jeder Zeit eine dieser beiden gegenläufigen Komponenten orthogonal zum Magnetisierungsvektor sein und ein Drehmoment auf diesen ausüben, so daß er graduell von seiner Anfangsposition längs $B_1$ weggezogen wird auf einen Pfad auf der Einheitskugel, der von der y-Achse nach außen wegspiralt, durch die xz-Ebene stößt und dann wieder nach innen spiralt um mit der -y-Achse zu konvergieren. Von da wird er wieder nach außen zur xz-Ebene spiralen und dann wieder zur +y-Achse in einer periodischen Bewegung zurückkehren. Die Periode dieser Bewegung ist $2\pi/(\gamma_2B_2)$. Der Spin-Lock-Impuls muß nach einer ganzzahligen Anzahl solcher Bewegungszyklen unterbrochen werden, so daß die Magnetisierung längs der +y-Achse liegt und damit die Beobachtung eines Meßsignales erlaubt.

Wenn $\gamma_1B_1/2\pi$ üblicherweise in der Größenordnung von 50 Hz liegt, könnte $\gamma_2B_2/2\pi$ ungefähr zu 5 Hz gewählt werden, d.h. die Periode der Spiralbewegung würde etwa 0.2 s betragen. Daher bedeutet das $B_2$-Feld in Gl. (11) lediglich eine geringe Störung im Hinblick auf das $B_1$-Feld. Die Resultierende der zwei orthogonalen Vektoren besitzt eine zeitabhängige Phase, die durch einen Bereich von lediglich $\pm 5.7°$ um die y-Achse wobbelt.

Mit dem in Gl. (11) beschriebenen Experiment kann man Kreuzrelaxationen zwischen zwei ausgewählten Spins studieren. Wenn man die Anfangsbedingung von Gl. (12) betrachtet, bei der beide Vektoren längs der y-Achse zu Beginn der Spin-Lock-Periode ausgerichtet sind, wird es klar, daß sie ähnlichen Pfaden folgen, vorausgesetzt, man betrachtet jeden Vektor in seinem eigenen rotierenden Koordinatensystem. In einem gemeinsamen Bezugssystem, beispielsweise in einem Bezugssystem, das mit der Trägerfrequenz $\omega_{rf}$ rotiert, würden ihre Pfade recht unterschiedlich erscheinen. Wenn wir dennoch unsere Aufmerksamkeit auf die longitudinalen Komponenten $I_z^A$ und $I_z^X$ richten, finden wird, daß ihre Zeitabhängigkeit identisch ist:

$$I_z^A=I_z^X=\sin\gamma_2B_2\tau_m\sin\gamma_1B_1\tau_m \tag{14}$$

Daher wird diesen beiden z-Komponenten eine synchrone Nutationsbewegung aufgezwungen. Dies impliziert, daß sie einer Kreuzrelaxation unterworfen sind, die nach dem Verfahren der "invarianten Trajektorien" berechnet werden kann. Wenn man die Anfangsbedingung von Gl. (13) wählt, bleiben die longitudinalen Magnetisierungskomponenten zu allen Zeiten während des Aufzwingens der Nutationsbewegung entgegengesetzt gerichtet. Im Grenzfall langsamer Bewegung führt die Kreuzrelaxation zu einem beschleunigten Zerfall der Differenzmode, während die Summenmode im Grenzfall schneller Bewegung schneller zerfällt.

Bisher haben wir angenommen, daß die HF-Felder perfekt homogen sind. In Wirklichkeit unterliegt die Nutationsfrequenz um $B_1$ in Gl. (1), oder, für den Fall der Gl. (11) um $B_1$ und $B_2$ einer inhomogenen Verbreiterung. Daher sollten die Gln. (5) und (6) durch Hinzufügen einer monoton zerfallenden Funktion $f(\tau_m)$ ergänzt werden:

$$\Sigma(\tau_m)=\Sigma(0)\exp\{-R_1\tau_m\}\sin(\gamma B_1\tau_m)f(\tau_m) \tag{15}$$

$$\Delta(\tau_m)=\Delta(0)\exp\{-R_2\tau_m\}\sin(\gamma B_1\tau_m)f(\tau_m) \tag{16}$$

Falls die räumliche Verteilung der HF-Feldamplituden eine Lorentzform aufweist, wird die Funktion $f(\tau_m)$ exponentiell sein. Während inhomogene Verbreiterung die Kreuzrelaxation, die selbstverständlich intramolekular ist, d.h. zwischen Spins stattfindet, die das gleiche HF-Feld "sehen", nicht beeinflußt, wirkt sie sich auf die Beobachtungsgrößen aus, weil diese Mittelwerte über die gesamte ausgedehnte Probe darstellen. Glücklicherweise ist es möglich, die negativen Effekte des inhomogenen Zerfalls durch Schalten der Phase von $B_1$ (und ggf. auch von $B_2$) durch 180° in der Mitte eines Zeitintervalls $\tau_m$ zu bekämpfen. Falls Diffusion ein Problem ist, ist es möglich, die HF-Phasen mehrmals in gleichbleibenden Intervallen zu schalten. Wenn die Differenz der chemischen Verschiebungen $\Omega_A - \Omega_X = 2\omega_a$ beträgt, kann gezeigt werden, daß die HF-Phase in Intervallen geschaltet werden muß, die Vielfachen von $\pi/\omega_a$ entsprechen, um destruktive Interferenz zu vermeiden. Auf diese Weise wird eine inhomogene Dephasierung refokussiert, um ein Rotationsecho am Ende der Spin-Lock-Periode zu bilden.

Beim Modulationsschema von Gl. (1) wird die Bestrahlung mit dem HF-Feld nach einer ganzzahligen Anzahl von Modulationszyklen $2\pi/\gamma_1 B_1$ unterbrochen, so daß die Magnetisierung sich wieder längs der z-Achse befindet. Von da kann sie in eine beobachtbare transversale Magnetisierung konvertiert werden, in dem z.B. ein 270°-Gauß-Impuls bei einer der Resonanzfrequenzen, oder ein amplitudenmodulierter 270°-Gauß-Impuls, der simultan beide Resonanzfrequenzen trifft, oder ein nicht-selektiver 90°-Impuls angelegt wird. Unabhängig von dem gewählten Schema ist jedoch eine Phasenalternierung des Leseimpulses, kombiniert mit einer alternierenden Addition und Subtraktion des Meßsignals empfehlenswert, um sicherzustellen, daß man wirklich die übrigbleibende z-Magnetisierung und nicht irgendwelche anderen übrigbleibenden transversalen Komponenten mißt.

Betrachtet man Spinsysteme, die einen oder mehrere passive Spins M, K, etc. enthalten, so werden die Kreuzrelaxationsraten $\sigma'_{AM}$ und $\sigma'_{KX}$ alle während der modulierten HF-Bestrahlung unterdrückt. Fig. 5 zeigt Simulationen, die diese entscheidende Behauptung belegen. Bei den Kurven 7 und 11 wird keiner der beiden Magnetisierungsvektoren durch die HF-Bestrahlung zur Nutation gezwungen, so daß man normale Kreuzrelaxation im Laborsystem beobachtet. Die Kurve 8 zeigt den Zerfall von $I_z^A$, wenn lediglich der Spin X durch eines der beiden Seitenbänder der amplitudenmodulierten HF-Bestrahlung berührt wird. Kurve 9 zeigt den oszillierenden Zerfall von $I_z^A$, wenn nur der Spin A durch eines der beiden Seitenbänder der amplitudenmodulierten HF-Bestrahlung berührt wird und Kurve 10 zeigt das Fehlen eines Aufbaus von $I_z^X$, wenn entweder der Spin X oder der Spin A durch eines der beiden Seitenbänder berührt wird. Diese Simulationen beweisen, daß Kreuzrelaxation effektiv unterdrückt wird, wenn lediglich einer der beiden Spins zur Nutation gezwungen wird, der andere aber nicht. Dies ermöglicht es, die Kreuzrelaxationsrate $\sigma_{AX}$ zwischen zwei ausgewählten Spins so zu untersuchen, als ob diese beiden Spins von den umgebenden Spins isoliert wären, vorausgesetzt natürlich, daß die chemischen Verschiebungen der beiden aktiven Spins unterschiedlich voneinander sind und sich auch von denen der passiven Spins unterscheiden.

Wenn diese Bedingungen erfüllt sind, ist es möglich, internukleare Abstände direkt aus den Kreuzrelaxationsraten zu bestimmen, die mit den oben vorgeschlagenen Anregungsschemata gemessen werden können, und zwar sogar in Fällen, wo normale Overhauser-Effekte im Laborsystem durch benachbarte Spins stark gestört werden.

## Patentansprüche

1. Verfahren zur Messung von Kreuzrelaxationsraten im Laborsystem in der hochauflösenden Kernspinresonanzspektroskopie, bei dem eine vorzugsweise in einer Flüssigkeit gelöste Probensubstanz mit Kernen A und X, die unterschiedliche chemische Verschiebungen $\Omega_A$ und $\Omega_X$ aufweisen, in einem homogenen statischen Magnetfeld $B_0$ in Richtung einer z-Achse, welches einer Ausrichtung der longitudinalen Komponenten $\vec{I_z^A}$, $\vec{I_z^X}$ der Magnetisierungsvektoren $I^A$, $I^X$ der Kerne A, X bewirkt, während eines Zeitintervalls $\tau_m$ mit einem HF-Feld bestrahlt und anschließend die longitudinale Magnetisierung durch eine geeignete HF-Impulssequenz in eine transversale Magnetisierung übergeführt wird, welche ein HF-Signal erzeugt, das mit einem Detektor aufgenommen wird, dadurch gekennzeichnet, daß das HF-Feld aus mindestens zwei schwachen, selektiven Teilfeldern zusammengesetzt ist, deren Frequenzen so gewählt sind, daß die Magnetisierungsvektoren $\vec{I^A}$ und $\vec{I^X}$ in eine synchrone Nutationsbewegung versetzt werden, während alle übrigen Kernspins der Probensubstanz im wesentlichen davon unbeeinflußt bleiben.

2. Verfahren nach Anspruch 1, dadurch gekennzeichnet, daß die Amplituden und Frequenzen der Teilfelder so gewählt werden, daß sie zusammen ein amplitudenmoduliertes HF-Feld in Richtung einer zur z-Achse orthogonalen y-Achse mit einer Trägerfrequenz $\omega_{rf} = 1/2 (\Omega_A + \Omega_X)$ und zwei Seitenbandfrequenzen $\omega_{rf} + \omega_a$ und $\omega_{rf} - \omega_a$ ergeben, wobei $\omega_a = 1/2 (\Omega_A - \Omega_X)$ bedeutet.

3. Verfahren nach Anspruch 2, dadurch gekennzeichnet, daß die Feldamplitude des zusammengesetzten HF-Feldes der Funktion $2\gamma_1 B_1 \cos \omega_{at}$ folgt, wobei $\gamma_1 B_1/2\pi$ die Amplitude der beiden Seitenbänder bedeutet.

4. Verfahren nach Anspruch 2 oder 3, dadurch gekennzeichnet, daß die Seitenbandamplituden $\gamma_1 B_1/2\pi$ so groß gewählt werden, daß allen Spins der Kerne A und X eine Nutationsbewegung derselben Nutationsfrequenz aufgezwungen wird, aber klein genug, um die Spins aller benachbarten andersartigen Kerne nicht zu beeinflussen, insbesondere $10\ Hz \leq \gamma_1 B_1/2\pi \leq 100\ Hz$, vorzugsweise $\gamma_1 B_1/2\pi \approx 50\ Hz$.

5. Verfahren nach Anspruch 3 oder 4, dadurch gekennzeichnet, daß das Zeitintervall $\tau_m$ als ganzzahliges Vielfaches

der Dauer eines Modulationszyklus $2\pi/\gamma_1B_1$ gewählt wird.

6. Verfahren nach Anspruch 1, dadurch gekennzeichnet, daß die Phasen der Teilfelder um 90° gegeneinander verschoben sind und ihre Amplituden und Frequenzen so gewählt werden, daß sie zusammen ein phasenmoduliertes HF-Feld orthogonal zur z-Achse mit einer Trägerfrequenz $\omega_{rf} = 1/2\,(\Omega_A + \Omega_X)$ und zwei Seitenbandfrequenzen $\omega_{rf} + \omega_a$ und $\omega_{rf} - \omega_a$ ergeben, wobei $\omega_a = 1/2\,(\Omega_A - \Omega_X)$ bedeutet.

7. Verfahren nach Anspruch 6, dadurch gekennzeichnet, daß die Feldamplitude eines Teilfeldes der Funktion $\gamma_1B_1 \cdot \cos\omega_{at}$ und die Feldamplitude eines anderen Teilfeldes der Funktion $\gamma_2B_2 \cdot \cos\omega_a t \cdot \cos\gamma_1B_1 t$ folgt, wobei $\gamma_1B_1/2\pi$ die Extremamplitude des einen Teilfeldes und $\gamma_2B_2/2\pi$ die Extremamplitude des anderen Teilfeldes bedeuten.

8. Verfahren nach Anspruch 7, dadurch gekennzeichnet, daß das Zeitintervall $\tau_m$ als ganzzahliges Vielfaches einer Zyklusdauer $2\pi/\gamma_2B_2$ gewählt wird.

9. Verfahren nach Anspruch 7 oder 8, dadurch gekennzeichnet, daß die Extremamplituden $\gamma_1B_1/2\pi$ und $\gamma_2B_2/2\pi$ so gewählt werden, daß $10\,\text{Hz} \leq \gamma_1B_1/2\pi \leq 100\,\text{Hz}$, vorzugsweise $\gamma_1B_1/2\pi \approx 50\,\text{Hz}$, und $\gamma_1B_1/\gamma_2B_2 \geq 1$, insbesondere $\gamma_1B_1/\gamma_2B_2 \approx 10$.

10. Verfahren nach einem der vorhergehenden Ansprüche, dadurch gekennzeichnet, daß die Phasen aller Teilfelder während des Zeitintervalls $\tau_m$ mindestens einmal um 180° geklappt werden.

11. Verfahren nach Anspruch 10, dadurch gekennzeichnet, daß die Anzahl der Phasenumklappungen während eines Zeitintervalls $\tau_m$ ungeradzahlig und die zeitliche Dauer $\tau_{180}$ der Einstrahlung des HF-Feldes mit um 180° geklappter Phase gleich der zeitlichen Dauer $\tau_0$ der Einstrahlung des HF-Feldes mit um 0° geklappter Phase gewählt werden.

12. Verfahren nach Anspruch 11, dadurch gekennzeichnet, daß die Zeitdauern der einzelnen Intervalle $\tau_{180}$, $\tau_0$ mit umgeklappter Phase jeweils gleich und als ungeradzahliges Vielfaches von $\pi/\omega_a$ gewählt werden.

13. Verfahren nach einem der vorhergehenden Ansprüche, dadurch gekennzeichnet, daß die Probensubstanz vor Einstrahlung des zusammengesetzten HF-Feldes mit einer geeignet geformten selektiven HF-Impulssequenz bestrahlt wird, welche eine Invertierung der Spinpolarisation der Kerne X gegenüber den Kernen A bewirkt.

14. Verfahren nach Anspruch 13, dadurch gekennzeichnet, daß die selektive HF-Impulssequenz eine $G^3$-Gauß-Impulskaskade enthält.

15. Verfahren nach Anspruch 13, dadurch gekennzeichnet, daß die selektive HF-Impulssequenz bandselektive "Uniform response pure phase"-Impulse aufweist.

16. Verfahren nach einem der Ansprüche 1 bis 12, dadurch gekennzeichnet, daß die Probensubstanz vor Einstrahlung des zusammengesetzten HF-Feldes mit einer HF-Impulssequenz bestrahlt wird, welche eine transversale Magnetisierung der Kerne A und X anregt.

17. Verfahren nach Anspruch 16, dadurch gekennzeichnet, daß die HF-Impulssequenz mit $\sin\omega_a t$ oder $\cos\omega_a t$ amplitudenmoduliert ist.

18. Verfahren nach Anspruch 17, dadurch gekennzeichnet, daß die selektive HF-Impulssequenz einen 270°-Gauß-Impuls enthält.

19. Verfahren nach Anspruch 17, dadurch gekennzeichnet, daß die selektive HF-Impulssequenz eine $G^4$-Gauß-Kaskade enthält.

20. Verfahren nach einem der Ansprüche 1 bis 15, dadurch gekennzeichnet, daß durch skalare Kopplung zwischen den Spins der Kerne A und X bedingte Modulationen der Meßgrößen vom langsamen inkohärenten Spinaustausch zwischen den Kernen A und X durch Fourier-Transformation bezüglich $\tau_m$ abgespalten werden.

21. Verfahren nach einem der Ansprüche 1 bis 15, dadurch gekennzeichnet, daß bei aufeinanderfolgenden Messungen das jeweilige Zeitintervall $\tau_m$ um ganzzahlige Vielfache der Schwingungsperiode, die von einer skalaren Kopplung zwischen den Spins der Kerne A und X verursacht wird, inkrementiert wird.

22. Verfahren nach einem der vorhergehenden Ansprüche, dadurch gekennzeichnet, daß als Leseimpuls unmittelbar nach Abschluß der Bestrahlung mit dem zusammengesetzten HF-Feld ein 270°-Gauß-Impuls mit der Frequenz einer der beiden chemischen Verschiebungen $\Omega_A$ oder $\Omega_X$ eingestrahlt wird.

23. Verfahren nach einem der Ansprüche 2 bis 21, dadurch gekennzeichnet, daß als Leseimpuls unmittelbar nach Abschluß der Bestrahlung mit dem zusammengesetzten HF-Feld ein 270°-Gauß-Impuls eingestrahlt wird, der mit der Funktion $\cos\omega_a t$ amplitudenmoduliert wird.

24. Verfahren nach einem der Ansprüche 1 bis 21, dadurch gekennzeichnet, daß als Leseimpuls unmittelbar nach Abschluß der Bestrahlung mit dem zusammengesetzten HF-Feld ein nicht-selektiver $\pi/2$-Impuls eingestrahlt wird.

25. Verfahren nach einem der Ansprüche 22 bis 24, dadurch gekennzeichnet, daß die Phase der Leseimpulse alterniert wird und damit gekoppelt das Meßsignal im Detektor alternierend addiert bzw. subtrahiert wird.


## Claims

1. Method for measuring cross-relaxation rates in the laboratory system in high-resolution nuclear magnetic resonance (NMR) spectroscopy in which in a homogeneous static magnetic field $B_0$ in a direction of a z-axis which causes alignment of longitudinal components $I_z^A$, $I_z^X$ of magnetization vectors $\vec{I}^A$, $\vec{I}^X$ of nuclei A, X during a time interval $\tau_m$ a sample substance,

    preferably dissolved in liquid, with nuclei A and X having different chemical shifts $\Omega_A$ and $\Omega_X$ is irradiated with an rf field and afterwards by action of a suitable rf-pulse sequence the longitudinal magnetization is transferred into a transverse magnetization creating an rf-signal received by a detector,
    characterized in that,
    the rf field is composed by at least two weak,
    selective component fields, the frequencies of these fields being chosen such that the magnetization vectors $\vec{I}^A$ and $\vec{I}^X$ are made to nutate in synchronous fashion, the remaining spins of the sample substance substantially being unaffected by this process.

2. Method according to claim 1, characterized in that the amplitudes and frequencies of the component fields are chosen such that together they form an amplitude-modulated rf field in direction of a y-axis orthogonal to the z-axis with a carrier frequency $\omega_{rf} = \frac{1}{2} (\Omega_A + \Omega_X)$ and two sideband frequencies $w_{rf} + \omega_a$ and $\omega_{rf} - \omega_a$, with $\omega_a = \frac{1}{2} (\Omega_A - \Omega_X)$.

3. Method according to claim 2, characterized in that the field amplitude of the composite rf field follows the function $2\gamma_1 B_1 \cos\omega_a t$, whereby $\gamma_1 B_1/2\pi$ is the amplitude of the two sidebands.

4. Method according to claim 2 or 3, characterized in that the sideband amplitudes $\gamma_1 B_1/2\pi$ are chosen sufficiently large to excite the spins of the nuclei A and X to nutate with the same nutation frequency, but weak enough so that the spins of all neighboring other nuclei are not affected, in particular $10\ \text{Hz} \leq \gamma_1 B_1/2\pi \leq 100\ \text{Hz}$, preferably $\gamma_1 B_1/2\pi \approx 50\ \text{Hz}$.

5. Method according to claim 3 or 4, characterized in that the time interval $\tau_m$ is chosen to be an integer multiple of the duration of a modulation cycle $2\pi/\gamma_1 B_1$.

6. Method according to claim 1, characterized in that the phases of the component fields are displaced from each other by 90° and their amplitudes and frequencies are chosen such that together they yield a phase-modulated rf field orthogonal to the z-axis with a carrier frequency $\omega_{rf} = \frac{1}{2} (\Omega_A + \Omega_X)$ and two sideband frequencies $\omega_{rf} + \omega_a$ and $\omega_{rf} - \omega_a$, with $\omega_a = \frac{1}{2} (\Omega_A - \Omega_X)$.

7. Method according to claim 6, characterized in that the field amplitude of a component field follows the function $\gamma_1 B_1 \cdot \cos\omega_a t$ and the field amplitude of another component field follows the function $\gamma_2 B_2 \cdot \cos\omega_a t \cdot \cos\gamma_1 B_1 t$, with

$\gamma_1 B_1/2\pi$ denoting the peak amplitude of the one component field and $\gamma_2 B_2/2\pi$ the peak amplitude of the other component field.

8. Method according to claim 7, characterized in that the time interval $\tau_m$ is chosen to be an integer multiple of the duration of a modulation cycle $2\pi/\gamma_2 B_2$.

9. Method according to claim 7 or 8, characterized in that the extreme amplitudes $\gamma_1 B_1/2\pi$ and $\gamma_2 B_2/2\pi$ are chosen so that $10\,Hz \leq \gamma_1 B_1/2\pi \leq 100\,Hz$, preferably $\gamma_1 B_1/2\pi \approx 50\,Hz$, and $\gamma_1 B_1/\gamma_2 B_2 \geq 1$, particularly $\gamma_1 B_1/\gamma_2 B_2 \approx 10$.

10. Method according to anyone of the preceding claims, characterized in that the phases of all component fields are flipped through 180° at least once during the time interval $\tau_m$.

11. Method according to claim 10, characterized in that the phases are flipped an odd number of times during a time interval $\tau_m$ and the time duration $\tau_{180}$ of the irradiation of the rf field with a phase flipped through 180° is chosen to be equal to the time duration $\tau_0$ of the irradiation of the rf field with a phase flipped through 0°.

12. Method according to claim 11, characterized in that the time durations of the single intervals $\tau_{180}, \tau_0$ with flipped phase are preferably chosen to be equal and an odd multiple of $\pi/\omega_a$.

13. Method according to anyone of the preceding claims, characterized in that the sample substance prior to irradiation of the composite rf field is irradiated with a suitably shaped selective rf pulse sequence causing an inversion of the spin polarization of the nuclei X in relation to the nuclei A.

14. Method according to claim 13, characterized in that the selective rf pulse sequence contains a $G^3$ Gaussian pulse cascade.

15. Method according to claim 13, characterized in that the selective rf pulse sequence contains band-selective "uniform response pure phase" pulses.

16. Method according to one of the claims 1 through 12, characterized in that the sample substance prior to the irradiation of the composite rf field is irradiated with an rf pulse sequence which excites transverse magnetization of the nuclei A and X.

17. Method according to claim 16, characterized in that the rf pulse sequence is amplitude modulated by $\sin\omega_a t$ or $\cos\omega_a t$.

18. Method according to claim 17, characterized in that the selective rf pulse sequence contains a 270° Gaussian pulse.

19. Method according to claim 17, characterized in that the selective rf pulse sequence contains a $G^4$ Gaussian cascade.

20. Method according to one of the claims 1 through 15, characterized in that modulations of the measuring variables caused by scalar coupling between the spins of the nuclei A and X are separated from the slow incoherent spin exchange between nuclei A and X by Fourier transformation with respect to $\tau_m$.

21. Method according to one of the claims 1 through 15, characterized in that in the sequential measurements the respective time interval $\tau_m$ is incremented in integer multiples of the period of oscillation caused by the scalar coupling between the spins of the nuclei A and X.

22. Method according to anyone of the preceding claims, characterized in that a 270° Gaussian pulse with the frequency of one of the two chemical shifts $\Omega_A$ or $\Omega_X$ is irradiated as read pulse immediately after irradiation with the composite rf field.

23. Method according to one of the claims 2 through 21, characterized in that a 270° Gaussian pulse which is modulated in amplitude by the function $\cos\omega_a t$ is irradiated as read pulse immediately after irradiation with the composite rf field.

24. Method according to one of the claims 1 through 21, characterized in that a non-selective $\pi/2$ pulse is irradiated as read pulse immediately after irradiation with the composite rf field.

25. Method according to one of the claims 22 through 24, characterized in that the phase of the read pulses is alternated and combined with it the measuring signal in the detector is alternatingly added or subtracted.

## Revendications

1. Procédé pour la mesure de taux de relaxation croisée dans le système du laboratoire pour la spectroscopie de résonance de spin nucléaire à haute résolution, selon lequel une substance d'essai de préférence dissoute dans un liquide, avec des noyaux A et X qui présentent des écarts chimiques différents $\Omega_A$ et $\Omega_X$, est exposée à un champ de haute fréquence pendant un intervalle de temps $\tau_m$ en direction d'un axe z dans un champ magnétique statique homogène $B_o$ qui produit une orientation des composantes longitudinales $I_z{}^A$, $I_z{}^X$ des vecteurs de magné-tisation $\vec{I}^A$, $\vec{I}^X$ des noyaux A, X, à la suite de quoi la magnétisation longitudinale est, par une séquence appropriée d'impulsions à haute fréquence, transformée en une magnétisation transversale qui produit un signal H.F. qui est reçu par un détecteur,
caractérisé en ce que le champ de haute fréquence est composé d'au moins deux champs partiels sélectifs faibles, dont les fréquences sont choisies de telle sorte que les vecteurs de magnétisation $\vec{I}^A$ et $\vec{I}^X$ sont déplacés en un mouvement de nutation synchrone, tandis que tous les autres spins nucléaires de la substance d'essai n'en subissent essentiellement aucune influence.

2. Procédé selon la revendication 1, caractérisé en ce que les amplitudes et fréquences des champs partiels sont choisies de telle sorte qu'elles fournissent conjointement un champ de haute fréquence modulé en amplitude en direction d'un axe y orthogonal à l'axe z, avec une fréquence porteuse $\omega_{rf} = 1/2 \, (\Omega_A + \Omega_X)$ et deux fréquences de bande latérale $\omega_{rf} + \omega_a$ et $\omega_{rf} - \omega_a$, où $\omega_a = 1/2(\Omega_A - \Omega_X)$.

3. Procédé selon la revendication 2, caractérisé en ce que l'amplitude du champ de haute fréquence composé suit la fonction $2\gamma_1 B_1 \cos\omega_a t$, où $\gamma_1 B_1/2\pi$ est l'amplitude des deux bandes latérales.

4. Procédé selon la revendication 2 ou 3, caractérisé en ce que les amplitudes de bande latérale $\gamma_1 B_1/2\pi$ sont choisies suffisamment grandes pour imprimer un mouvement de nutation de la même fréquence de nutation à tous les spins des noyaux A et X, mais suffisamment petites pour ne pas influencer les spins de tous les noyaux voisins d'autres types, notamment $10 \text{ Hz} \leq \gamma_1 B_1/2\pi \leq 100 \text{ Hz}$, de préférence $\gamma_1 B_1/2\pi \approx 50 \text{ Hz}$.

5. Procédé selon la revendication 3 ou 4, caractérisé en ce que l'intervalle de temps $\tau_m$ est choisi égal à un multiple entier de la durée d'un cycle de modulation $2\pi/\gamma_1 B_1$.

6. Procédé selon la revendication 1, caractérisé en ce que les phases des champs partiels sont mutuellement décalées de 90°, et leurs amplitudes et fréquences sont choisies de telle sorte qu'elles fournissent conjointement un champ de haute fréquence modulé en phase orthogonalement à l'axe z, avec une fréquence porteuse $\omega_{rf} = 1/2 \, (\Omega_A + \Omega_X)$ et deux fréquences de bande latérale $\omega_{rf} + \omega_a$ et $\omega_{rf} - \omega_a$, où $\omega_a = 1/2(\Omega_A - \Omega_X)$.

7. Procédé selon la revendication 6, caractérisé en ce que l'amplitude d'un champ partiel suit la fonction $\gamma_1 B_1 . \cos\omega_a t$ et l'amplitude d'un autre champ partiel suit la fonction $\gamma_2 B_2 . \cos\omega_a t . \cos\gamma_1 B_1 t$, où $\gamma_1 B_1/2\pi$ est l'amplitude extrême du premier champ partiel et $\gamma_2 B_2/2\pi$ est l'amplitude extrême de l'autre champ partiel.

8. Procédé selon la revendication 7, caractérisé en ce que l'intervalle de temps $\tau_m$ est choisi égal à un multiple entier d'une durée de cycle $2\pi/\gamma_2 B_2$.

9. Procédé selon la revendication 7 ou 8, caractérisé en ce que les amplitudes extrêmes $\gamma_1 B_1/2\pi$ et $\gamma_2 B_2/2\pi$ sont choisies de telle sorte que $10 \text{ Hz} \leq \gamma_1 B_1/2\pi \leq 100 \text{ Hz}$, de préférence $\gamma_1 B_1/2\pi \approx 50 \text{ Hz}$, et $\gamma_1 B_1/\gamma_2 B_2 \geq 1$, notamment $\gamma_1 B_1/\gamma_2 B_2 \approx 10$.

10. Procédé selon une des revendications précédentes, caractérisé en ce que les phases de tous les champs partiels sont renversées au moins une fois de 180° pendant l'intervalle de temps $\tau_m$.

**11.** Procédé selon la revendication 10, **caractérisé** en ce que le nombre de renversements de phase pendant un intervalle de temps $\tau_m$ est choisi impair, et la durée $\tau_{180}$ de l'irradiation du champ de haute fréquence avec une phase renversée de 180° est choisie égale à la durée $\tau_0$ de l'irradiation du champ de haute fréquence avec une phase renversée de 0°.

**12.** Procédé selon la revendication 11, **caractérisé** en ce que les durées des intervalles individuels $\tau_{180}$, $\tau_0$ à phase renversée sont chaque fois choisies identiques et comme multiple impair de $\pi/\omega_a$.

**13.** Procédé selon une des revendications précédentes, **caractérisé** en ce que la substance d'essai est, avant l'irradiation du champ de haute fréquence composé, exposée à une séquence sélective d'impulsions à haute fréquence de forme appropriée, qui produit une inversion de la polarisation des spins des noyaux X par rapport aux noyaux A.

**14.** Procédé selon la revendication 13, **caractérisé** en ce que la séquence sélective d'impulsions à haute fréquence comprend une cascade d'impulsions de Gauss $G^3$.

**15.** Procédé selon la revendication 13, **caractérisé** en ce que la séquence sélective d'impulsions à haute fréquence présente des impulsions "uniform response pure phase" sélectives en bande.

**16.** Procédé selon une des revendications 1 à 12, **caractérisé** en ce que la substance d'essai est, avant l'irradiation du champ de haute fréquence composé, exposée à une séquence d'impulsions à haute fréquence qui engendre une magnétisation transversale des noyaux A et X.

**17.** Procédé selon la revendication 16, **caractérisé** en ce que la séquence d'impulsions à haute fréquence est modulée en amplitude avec $\sin\omega_a t$ ou $\cos\omega_a t$.

**18.** Procédé selon la revendication 17, **caractérisé** en ce que la séquence sélective d'impulsions à haute fréquence comprend une impulsion de Gauss de 270°.

**19.** Procédé selon la revendication 17, **caractérisé** en ce que la séquence sélective d'impulsions à haute fréquence comprend une cascade de Gauss $G^4$.

**20.** Procédé selon une des revendications 1 à 15, **caractérisé** en ce que des modulations des grandeurs de mesure, produites par couplage scalaire entre les spins des noyaux A et X, sont séparées du lent échange incohérent de spins entre les noyaux A et X par transformation de Fourier par rapport à $\tau_m$.

**21.** Procédé selon une des revendications 1 à 15, **caractérisé** en ce que, lors de mesures successives, l'intervalle de temps respectif $\tau_m$ est incrémenté de multiples entiers de la période d'oscillation qui est provoquée par un couplage scalaire entre les spins des noyaux A et X.

**22.** Procédé selon une des revendications précédentes, **caractérisé** en ce que, comme impulsion de lecture juste après la fin de l'irradiation avec le champ de haute fréquence composé, on irradie une impulsion de Gauss de 270° avec la fréquence d'un des deux écarts chimiques $\Omega_A$ ou $\Omega_X$.

**23.** Procédé selon une des revendications 2 à 21, **caractérisé** en ce que, comme impulsion de lecture juste après la fin de l'irradiation avec le champ de haute fréquence composé, on irradie une impulsion de Gauss de 270° qui est modulée en amplitude avec la fonction $\cos\omega_a t$.

**24.** Procédé selon une des revendications 1 à 21, **caractérisé** en ce que, comme impulsion de lecture juste après la fin de l'irradiation avec le champ de haute fréquence composé, on irradie une impulsion $\pi/2$ non sélective.

**25.** Procédé selon une des revendications 22 à 24, **caractérisé** en ce que la phase des impulsions de lecture est alternée et le signal de mesure dans le détecteur est, en couplage avec cette alternance, alternativement additionné ou soustrait.

Fig. 1

Fig. 2

a)

b)

0

440 ms

c)

0

440 ms

Fig. 3

a)

$\Omega_A$ and $\Omega_X$ | $\Omega_A$ or $\Omega_X$

$\varphi$

0°

180°

$\tau_m$

b)

$\Omega_A$ or $\Omega_X$ | $\Omega_A$ and $\Omega_X$ | $\Omega_A$ or $\Omega_X$

$\varphi$

0°

180°

$\tau_m$

Fig. 4

c )

$\Omega_A$ and $\Omega_X$    $\Omega_A$ and $\Omega_X$    $\Omega_A$ or $\Omega_X$

0°

φ

180°

$\tau_m$

Fig. 4

a)

b)

Fig. 5